# EUROPÄISCHE PATENTANMELDUNG

(11) **EP 1 820 939 A1**
(43) Veröffentlichungstag der Anmeldung: **22.08.2007**
(21) Anmeldenummer: 06001110.3
(22) Anmeldetag: 19.01.2006
(51) Int. Cl.: F01D 5/28, C23C 4/00, C23C 14/54, C23C 16/04, B05C 13/00

(54) **Verfahren und Vorrichtung zur Beschichtung von Turbinenschaufeln**

(71) Anmelder: SIEMENS AKTIENGESELLSCHAFT, 80333 München (DE)
(72) Erfinder: Berndt, Thomas, 12524 Berlin (DE); Ladru, Francis-Jurjen, Dr., 14050 Berlin (DE); Reymann, Helge, 14167 Berlin (DE)

(57) **Zusammenfassung**

Die Erfindung betrifft ein Verfahren zur Beschichtung von Turbinenschaufeln (120, 130), die einen Schaufelfuß und ein Schaufelblatt aufweisen, in denen jeweils Kühlluftbohrungen (418) ausgebildet sind, die miteinander über Kanäle und/oder Hohlräume im Inneren der Turbinenschaufel (120, 130) verbunden sind, bei dem der Schaufelfuß (183) in einem Gehäuse (1) einer Beschichtungseinrichtung positioniert und fixiert wird und anschließend zumindest das Schaufelblatt (406) einen Beschichtungsvorgang unterzogen wird. Das Verfahren ist dadurch gekennzeichnet, dass während des Beschichtungsvorgangs Druckluft in das Gehäuse (1) eingeblasen wird, so dass sie durch die Kühlluftbohrungen (418) des Schaufelfußes (183) in die Turbinenschaufel eintritt, durch die Kanäle und/oder Hohlräume im Inneren der Turbinenschaufel (120, 130) zu den Kühlluftbohrungen des Schaufelblatts (406) geführt wird und über diese aus der Turbinenschaufel (120, 130) ausströmt.

## Beschreibung

Die vorliegende Erfindung betrifft ein Verfahren zur Beschichtung von Turbinenschaufeln, die einen Schaufelfuß und ein Schaufelblatt aufweisen, in denen jeweils Kühlluftbohrungen ausgebildet sind, die miteinander über Kanäle und/oder Hohlräume im Inneren der Turbinenschaufel verbunden sind, bei dem der Schaufelfuß in einem Gehäuse einer Beschichtungseinrichtung positioniert und fixiert wird und anschließend zumindest das Schaufelblatt einen Beschichtungsvorgang unterzogen wird. Des Weiteren betrifft die Erfindung eine Vorrichtung zur Durchführung des Verfahrens.

Hochbelastete Werkstücke wie beispielsweise Leit- und Laufschaufeln für Gasturbinen werden zur Verbesserung ihrer Temperatur- und/oder Abrasionsfestigkeit mit hierfür geeigneten Metallen, Metalllegierungen oder Keramiken beschichtet. Die Beschichtung kann mittels unterschiedlicher thermischer Beschichtungsverfahren erfolgen. Beispiele für solche Verfahren sind das aspherische Plasmasprüchen (APS) sowie das Hochgeschwindigkeits-Sauerstoff-Brennstoffsprühen (HVOF) (vgl. Ullmanns Encyclopaedia of Industrial Chemistry, 2003, Band 21, S. 573 und 575. Ebenso ist das Beschichtungsmittel Kaltgasspritzen bekannt.

Bei Turbinenschaufeln werden nur die Schaufelblätter, welche beim späteren Einsatz dem durchströmenden heißen Medium ausgesetzt sind, beschichtet, während der kaltgasseitige Schaufelfuß unbeschichtet bleibt und während des Beschichtungsprozesses in einer Halterung fixiert und abgedeckt wird. Hierzu besitzt die Halterung ein Gehäuse mit einer Öffnung, durch welche die Turbinenschaufel mit ihrem Schaufelfuß in das Gehäuse eingesetzt wird, so dass sie mit dem zu beschichtenden Schaufelblatt aus der Öffnung des Gehäuses herausragt. Der Schaufelfuß wird in dem Gehäuse durch entsprechende Positionierelemente sowie Spanneinrichtungen ausgerichtet und fixiert.

Während des anschließenden Beschichtungsvorgangs werden die Turbinenschaufeln hohen Temperaturen ausgesetzt. Aus diesem Grund werden die Turbinenschaufeln üblicherweise während des Beschichtens durch Druckluft von außen gekühlt. Es wird jedoch zum Teil als nachteilig angesehen, dass die Turbinenschaufeln durch die angeblasene Druckluft nur ungleichmäßig gekühlt werden kann und das Anblasen von der Außenseite auch aufwendig ist.

Aufgabe der vorliegenden Erfindung ist es daher, ein Verfahren zur Beschichtung von Turbinenschaufeln der eingangs genannten Art anzugeben, mit dem die Turbinenschaufeln während des Beschichtungsvorgangs gleichmäßig und auf einfache und effiziente Art gekühlt werden können. Des weiteren soll eine Vorrichtung zur Durchführung des Verfahrens angegeben werden.

Diese Aufgabe ist verfahrensmäßig dadurch gelöst, dass während des Beschichtungsvorgangs Druckluft in das Gehäuse eingeblasen wird, so dass sie durch die Kühlluftbohrungen des Schaufelfußes in die Turbinenschaufel eintritt, durch die Kanäle und/oder Hohlräume im Inneren der Turbinenschaufel zu den Kühlluftbohrungen des Schaufelblatts geführt wird und über diese aus der Turbinenschaufel ausströmt. Der Erfindung liegt damit die Überlegung zugrunde, die in den Turbinenschaufeln ohnehin vorhandenen Kühlluftbohrungen, die während des Betriebs in einer Gasturbine zur Kühlung der Turbinenschaufeln benutzt werden, auch während des Beschichtungsvorgangs zu nutzen, um die Turbinenschaufeln von innen her zu kühlen. Dazu wird kühle Druckluft mit einer gewünschten Temperatur in das Gehäuse, in welchem der Schaufelfuß der Turbinenschaufel positioniert und fixiert ist, eingeblasen, so dass sie über die im Bereich des Schaufelfußes vorgesehenen Kühlluftbohrungen in das Innere der Turbinenschaufel gelangt, durch die im Inneren der Turbinenschaufel vorgesehenen Kanäle bzw. Hohlräume zum Schaufelblatt geführt wird und über die dort vorgesehenen Kühlluftbohrungen aus der Turbinenschaufel wieder ausgeblasen wird.

Um in dem Gehäuse einen entsprechenden Druck aufbauen zu können, sollte das Gehäuse entsprechend dicht ausgebildet sein. Des Weiteren können Dichtungsmaßnahmen getroffen sein, um den Spalt zwischen dem Gehäuse und dem Schaufelfuß zu schließen.

Gemäß einer Ausführungsform der Erfindung ist vorgesehen, dass das Gehäuse durch eine Lageranordnung insbesondere um eine vertikale Achse drehbar gelagert ist und während des Beschichtungsvorgangs gedreht wird, wobei die Druckluft dem Innenraum des Gehäuses zentral und koaxial durch die Lageranordnung zugeführt wird. Bei dieser Ausführungsform erfolgt die Druckluftzufuhr zentral durch die Lageranordnung, so dass das Gehäuse während des Betriebs frei gedreht werden kann.

Gemäß einer weiteren Ausführungsform der Erfindung ist vorgesehen, dass die Druckluft mit einem Druck zugeführt wird, der so hoch ist, dass die aus den Kühlluftbohrungen des Schaufelblatts ausströmende Luft verhindert, dass sich die Kühlluftbohrungen durch das Beschichtungsmaterial zusetzen. Bei dieser Ausführungsform wird die Kühlluft genutzt, um zusätzlich die Kühlluftbohrungen von dem Beschichtungsmaterial frei zu halten oder zumindest in einer Verstopfung der Kühlluftbohrungen durch den Schichtniederschlag entgegenzuwirken.

Gegenstand der Erfindung ist des Weiteren eine Vorrichtung zum Beschichten von Turbinenschaufeln, bei der das Gehäuse in bereits beschriebener Weise einen Druckluftanschluss aufweist, um dem Innenraum des Gehäuses Druckluft zuzuführen. Die Druckluftzufuhr erfolgt hier zweckmäßigerweise über die Lagereinrichtung zentral durch die Lagereinrichtung, über welches Gehäuse drehbar an einem Maschinentisch oder dergleichen gelagert ist, so dass das Gehäuse während der Beschichtung frei gedreht werden kann. Hierbei kann die Lagereinrichtung ein rohrförmiges Halteelement und einen rohrförmig ausgebildeten Drehzapfen, welcher in das Halteelement eingreift, aufweisen, wobei dann die Druckluftzufuhr durch das Halteelement in den Drehzapfen erfolgt.

In der Zeichnung ist die Erfindung anhand von Ausführungsbeispielen näher veranschaulicht. Es zeigen:
- Figur 1: eine Ausführungsform einer erfindungsgemäßen Halterung einer Beschichtungsvorrichtung mit einer eingesetzten Turbinenschaufel in Vorderansicht,
- Figur 2: eine Turbinenschaufel in perspektivischer Ansicht,
- Figur 3: einen Querschnitt durch die Turbinenschaufel von Figur 2,
- Figur 4: eine Gasturbine im Längsschnitt und
- Figur 5: eine Brennkammer einer Gasturbine.

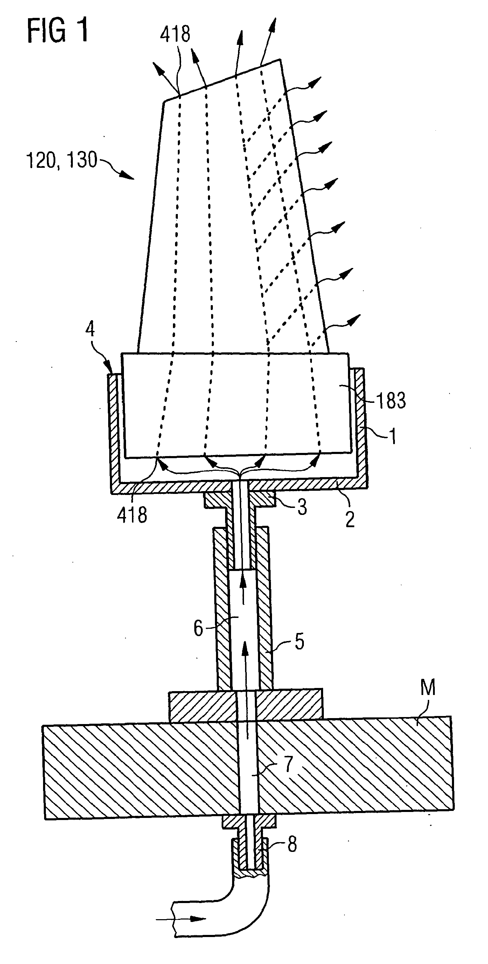

In der Figur 1 ist eine Ausführungsform einer Halterung vorgesehen, um eine Turbinenschaufel 120, 130 in beispielsweise einer thermischen Beschichtungsvorrichtung zu fixieren. Die Halterung besitzt ein im Wesentlichen quaderförmiges Gehäuse 1 mit einem Gehäuseboden 2, der an seiner Unterseite einen als Drehzapfen 3 ausgebildeten Gehäusefuß zur Anbringung an der Beschichtungsvorrichtung trägt. Die Oberseite des Gehäuses 1 ist offen ausgebildet und definiert eine begrenzte Öffnung 4, durch welche der Schaufelfuß 183 der einzuspannenden Turbinenschaufel 120, 130 in das Gehäuse 1 eingesetzt ist. Die Halterung weist weiterhin Positionier- und Spannmittel auf, um die Turbinenschaufel 120, 130 in dem Gehäuse 1 zu fixieren und fest zu spannen. Des Weiteren können Dichtungsmittel vorgesehen sein, um den zwischen dem Schaufelfuß 183 und dem Gehäuse 1 gebildeten Ringspalt zu verschließen.

Der an dem Gehäuseboden 2 vorgesehene Drehzapfen 3 ist drehbar in einem Lagerelement 5 gehalten. Das Lagerelement 5 ist hier als rohrförmiges Halteelement ausgebildet, welches an dem Maschinentisch M fixiert ist.

Wie die Figur 1 gut erkennen lässt, bilden das rohrförmige Halteelement 5 und der rohrförmig ausgebildete Drehzapfen 3 einen Kanal 6, der an seinem einen Ende in das Innere des Gehäuses 1 mündet und an seinem anderen Ende über einen Druckluftkanal 7, welcher in dem Maschinentisch M ausgebildet ist, mit einem Druckluftanschluss 8 verbunden ist, der an eine Druckluftquelle angeschlossen ist. Auf diese Weise kann dem Inneren des Gehäuses 1 über die Lageranordnung 3, 5 Druckluft zugeführt werden.

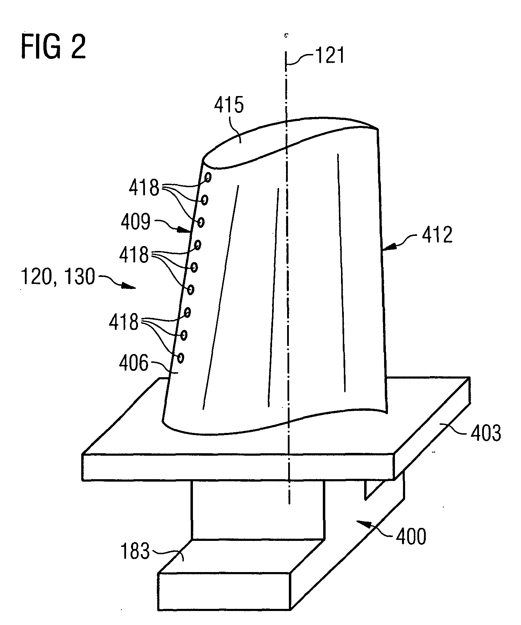

Die Figur 2 zeigt in perspektivischer Ansicht die Turbinenschaufel 120, 130 aus Figur 1, die eine Laufschaufel 120 oder Leitschaufel 130 einer Strömungsmaschine sein kann, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.

Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierung Teil der Offenbarung.

Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen; thermischen und/oder chemischen Belastungen ausgesetzt sind.

Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.

Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).

Solche Verfahren sind aus der US-PS 6,024,792 und der EP 0 892 090 A1 bekannt; diese Schriften sind bzgl. des Erstarrungsverfahrens Teil der Offenbarung.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen. Die Dichte liegt vorzugsweise bei 95% der theoretischen Dichte.

Auf der MCrAlX-Schicht (als Zwischenschicht oder als äußerste Schicht) bildet sich eine schützende Aluminiumoxidschicht (TGO = thermal grown oxide layer).

Auf der MCrAlX kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

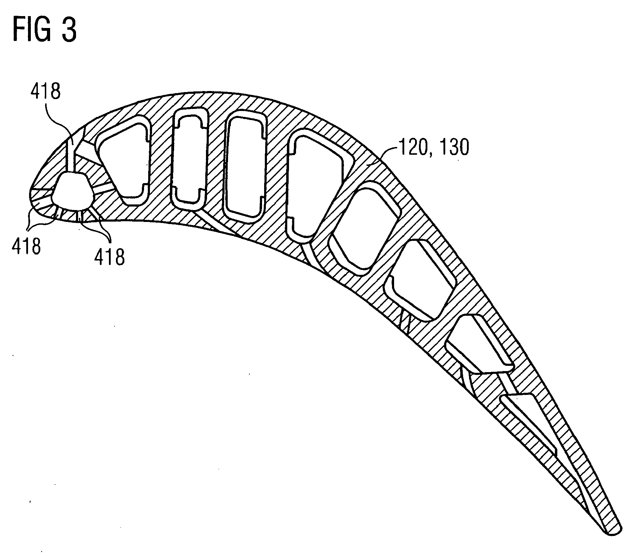

Wie in der Figur 3 gezeigt ist, ist die Schaufel 120, 130 hohl ausgeführt und weist an ihrem Schaufelblatt 406 eine Vielzahl von Kühlluftbohrungen 418 auf, über welche im Betrieb Kühlluft in das Innere der Schaufel 120, 130 geführt wird. In der Zeichnung nicht erkennbar ist, daß solche Kühlluftbohrungen 418 auch am Schaufelfuß 183 und insbesondere an dessen Unterseite ausgebildet sind. Die Kühlluftbohrungen 418 des Schaufelblatts 406 und des Schaufelfußes 183 stehen über die Hohlräume 9 bzw. Kanäle, welche in der Turbinenschaufel 120, 130 ausgebildet sind, miteinander in Verbindung.

Wenn während der Beschichtung Druckluft über den im Maschinentisch M ausgebildeten Druckluftkanal 7 und den in der Lageranordnung 3, 5 ausgebildeten Kanal 6 in das Gehäuse 1 geführt wird, tritt die Druckluft über die Kühlluftbohrungen 418 am Schaufelfuß 183 ein, verteilt sich in den Hohlräumen 9 und tritt durch die Kühlluftbohrungen 418 am Schaufelblatt 406 wieder aus der Turbinenschaufel 120, 130 aus. Die Turbinenschaufel 120, 130 wird durch die Druckluft von der Innenseite her gekühlt, so dass während des Beschichtungsvorgangs eine Kühlung von außen her nicht mehr erforderlich ist. In der Figur 1 ist der Druckluftstrom durch Pfeile bzw. gepunktete Linien angedeutet.

Dadurch, dass die Druckluft zentral durch das Lagerelement 5 und den Drehzapfen 3 geführt wird, kann das Gehäuse während der Beschichtung ohne Behinderung über Druckluftschläuche o. dgl. frei gedreht werden.

Im übrigen kann die Druckluft auch mit einem derart hohen Druck zugeführt werden, dass die Kühlluftbohrungen 418 des Schaufelblatts 406 während des Beschichtungsvorgangs durch die aus ihr austretende Luft freigehalten werden und sich kein Beschichtungsniederschlag (Coat-Down) in ihren sammelt.

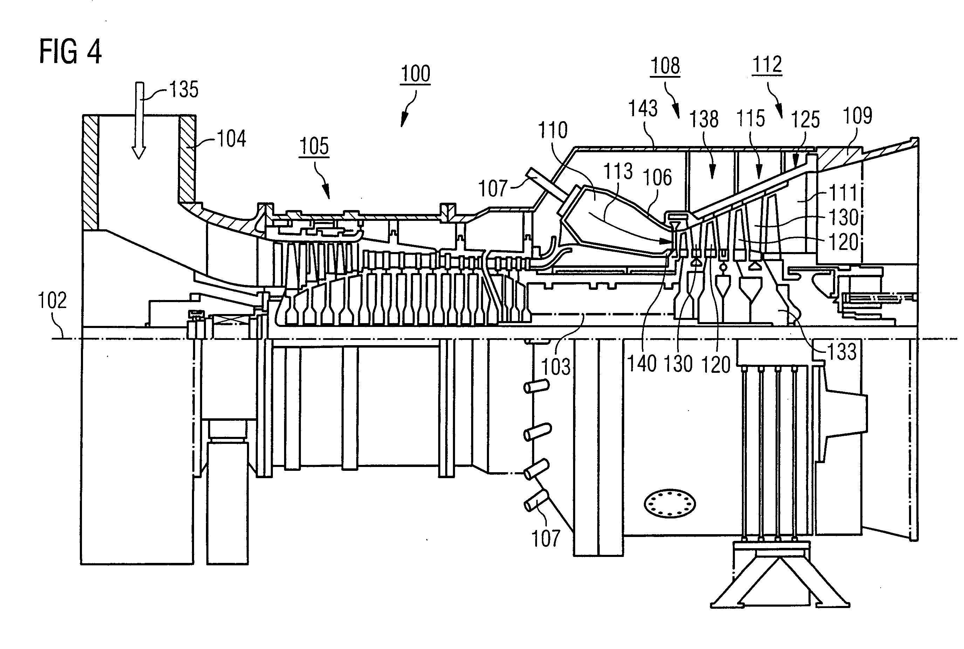

Lauf- und Leitschaufeln 120, 130 der oben beschriebenen Art werden in Gasturbinen verwendet. Die Figur 4 zeigt eine solche Gasturbine 100 in einem Längsteilschnitt. Mit Hilfe des erfindungsgemäßen Reparaturverfahren können die Schaufeln 120, 130 im Rahmen der Wiederaufarbeitung Instand gesetzt werden.

Die Gasturbine 100 weist im Inneren einen um eine Rotationsachse 102 drehgelagerten Rotor 103 mit einer Welle 101 auf, der auch als Turbinenläufer bezeichnet wird. Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.

Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet.

Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierungen Teil der Offenbarung.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

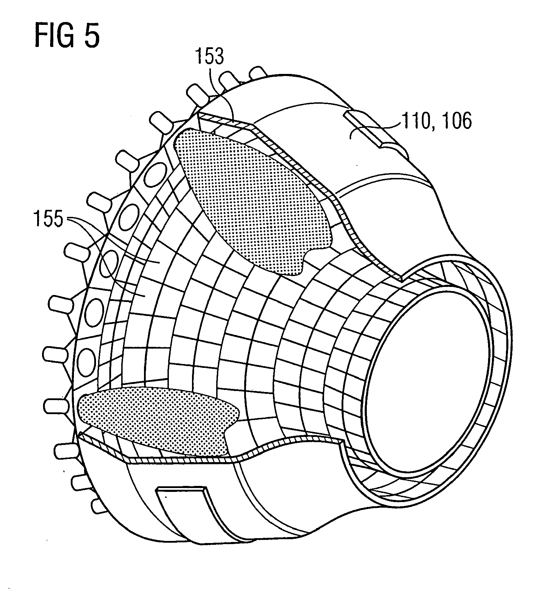

Die Figur 5 zeigt eine Brennkammer 110 einer Gasturbine. Mit Hilfe des erfindungsgemäßen Reparaturverfahrens können die Hitzeschutzelemente 155, = die Kühlluftbohrungen aufweisen können, im Rahmen der Wiederaufarbeitung Instand gesetzt werden.

Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen noch in den Brennkammerraum 154 mündende Kühlluftbohrungen (nicht dargestellt) auf.

Jedes Hitzeschildelement 155 aus einer Legierung ist arbeitsmediumsseitig mit einer besonders hitzebeständigen Schutzschicht (MCrAlX-Schicht und/oder keramische Beschichtung) ausgestattet oder ist aus hochtemperaturbeständigem Material (massive keramische Steine) gefertigt.

Diese Schutzschichten können ähnlich der Turbinenschaufeln sein, also bedeutet beispielsweise MCrAlX: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.

Auf der MCrAlX kann noch eine beispielsweise keramische Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen.

Wiederaufarbeitung (Refurbishment) bedeutet, dass Turbinenschaufeln 120, 130, Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in der Turbinenschaufel 120, 130 oder dem Hitzeschildelement 155 repariert. Danach erfolgt eine Wiederbeschichtung der Turbinenschaufeln 120, 130, Hitzeschildelemente 155 und ein erneuter Einsatz der Turbinenschaufeln 120, 130 oder der Hitzeschildelemente 155.

## Patentansprüche

1. Verfahren zur Beschichtung von Turbinenschaufeln (120, 130), die einen Schaufelfuß und ein Schaufelblatt aufweisen, in denen jeweils Kühlluftbohrungen (418) ausgebildet sind, die miteinander über Kanäle und/oder Hohlräume im Inneren der Turbinenschaufel (120, 130) verbunden sind, bei dem der Schaufelfuß (183) in einem Gehäuse (1) einer Beschichtungseinrichtung positioniert und fixiert wird und anschließend zumindest das Schaufelblatt (406) einen Beschichtungsvorgang unterzogen wird, **dadurch gekennzeichnet, dass** während des Beschichtungsvorgangs Druckluft in das Gehäuse (1) eingeblasen wird, so dass sie durch die Kühlluftbohrungen (418) des Schaufelfußes (183) in die Turbinenschaufel eintritt, durch die Kanäle und/oder Hohlräume im Inneren der Turbinenschaufel (120, 130) zu den Kühlluftbohrungen des Schaufelblatts (406) geführt wird und über diese aus der Turbinenschaufel (120, 130) ausströmt.

2. Verfahren nach Anspruch 1,
**dadurch gekennzeichnet, dass**
das Gehäuse (1) durch eine Lageranordnung (3, 5) insbesondere um eine vertikale Achse drehbar gelagert ist und während des Beschichtungsvorgangs gedreht wird, wobei die Druckluft dem Innenraum des Gehäuses zentral und koaxial durch die Lageranordnung (3, 5) zugeführt wird.

3. Verfahren nach Anspruch 1 oder 2,
**dadurch gekennzeichnet, dass**
die Druckluft mit einem Druck zugeführt wird, der so hoch ist, dass die aus den Kühlluftbohrungen (418) des Schaufelblatts ausströmende Luft verhindert, dass sich die Kühlluftbohrungen (418) durch das Beschichtungsmaterial zusetzen.

4. Vorrichtung zum Beschichten von Turbinenschaufeln (120, 130), die einen Schaufelfuß (183) und ein Schaufelblatt (406) aufweisen, in denen jeweils Kühlluftbohrungen (418) vorgesehen sind, die miteinander über Kanäle und/oder Hohlräume im Inneren der Turbinenschaufel (120, 130) verbunden sind, mit einem Gehäuse (1) zur Positionierung und Fixierung des Schaufelfußes (183),
**dadurch gekennzeichnet, dass**
das Gehäuse einen Druckluftanschluss aufweist, um dem Innenraum des Gehäuses (1) Druckluft zuzuführen.

5. Vorrichtung nach Anspruch 4,
**dadurch gekennzeichnet, dass**
eine Lagereinrichtung (3, 5) vorgesehen ist, über welche das Gehäuse (1) drehbar an einem Maschinentisch (M) oder dergleichen gelagert ist, und dass die Druckluftzufuhr zentral durch die Lagereinrichtung (3, 5) verläuft.

6. Vorrichtung nach Anspruch 5,
**dadurch gekennzeichnet, dass**
die Lagereinrichtung (3, 5) ein rohrförmiges Halteelement (5) und einen rohrförmig ausgebildeten Drehzapfen (3), welcher in das Halteelement (5) eingreift, aufweist und die Druckluftzufuhr durch das Halteelement und den Drehzapfen (3) erfolgt.

## Geänderte Patentansprüche

### Geänderte Patentansprüche gemäss Regel 86(2) EPÜ.

**1.** Verfahren zur Beschichtung von Turbinenschaufeln (120, 130), die einen Schaufelfuß und ein Schaufelblatt aufweisen, in denen jeweils Kühlluftbohrungen (418) ausgebildet sind, die miteinander über Kanäle und/oder Hohlräume im Inneren der Turbinenschaufel (120, 130) verbunden sind, bei dem der Schaufelfuß (183) in einem Gehäuse (1) einer Beschichtungseinrichtung positioniert und fixiert wird und anschließend zumindest das Schaufelblatt (406) einen Beschichtungsvorgang unterzogen wird, **dadurch gekennzeichnet, dass** während des Beschichtungsvorgangs Druckluft in das Gehäuse (1) eingeblasen wird, so dass sie durch die Kühlluftbohrungen (418) des Schaufelfußes (183) in die Turbinenschaufel eintritt, durch die Kanäle und/oder Hohlräume im Inneren der Turbinenschaufel (120, 130) zu den Kühlluftbohrungen des Schaufelblatts (406) geführt wird und über diese aus der Turbinenschaufel (120, 130) ausströmt.

**2.** Verfahren nach Anspruch 1,
**dadurch gekennzeichnet, dass**
das Gehäuse (1) durch eine Lageranordnung (3, 5) insbesondere um eine vertikale Achse drehbar gelagert ist und während des Beschichtungsvorgangs gedreht wird, wobei die Druckluft dem Innenraum des Gehäuses zentral und koaxial durch die Lageranordnung (3, 5) zugeführt wird.

**3.** Verfahren nach Anspruch 1 oder 2,
**dadurch gekennzeichnet, dass**
die Druckluft mit einem Druck zugeführt wird, der so hoch ist, dass die aus den Kühlluftbohrungen (418) des Schaufelblatts ausströmende Luft verhindert, dass sich die Kühlluftbohrungen (418) durch das Beschichtungsmaterial zusetzen.

**4.** Vorrichtung zum Beschichten von Turbinenschaufeln (120, 130), die einen Schaufelfuß (183) und ein Schaufelblatt (406) aufweisen, in denen jeweils Kühlluftbohrungen (418) vorgesehen sind, die miteinander über Kanäle und/oder Hohlräume im Inneren der Turbinenschaufel (120, 130) verbunden sind, mit einem Gehäuse (1) zur Positionierung und Fixierung des Schaufelfußes (183),
das Gehäuse einen Druckluftanschluss aufweist,
um dem Innenraum des Gehäuses (1) Druckluft zuzuführen
**dadurch gekennzeichnet, dass**
eine Lagereinrichtung (3, 5) vorgesehen ist,
über welche das Gehäuse (1) drehbar an einem Maschinentisch (M) oder dergleichen gelagert ist, und
dass die Druckluftzufuhr zentral durch die Lagereinrichtung (3, 5) verläuft.

**5.** Vorrichtung nach Anspruch 4,
**dadurch gekennzeichnet, dass**
die Lagereinrichtung (3, 5) ein rohrförmiges Halteelement (5) und einen rohrförmig ausgebildeten Drehzapfen (3), welcher in das Halteelement (5) eingreift, aufweist und
die Druckluftzufuhr durch das Halteelement und den Drehzapfen (3) erfolgt.
